# EUROPÄISCHE PATENTSCHRIFT

(11) **EP 0 933 874 B1**
(45) Veröffentlichungstag und Bekanntmachung des Hinweises auf die Patenterteilung: **05.11.2003**
(21) Anmeldenummer: 98122166.6
(22) Anmeldetag: 25.11.1998
(51) Int. Cl.: H03K 19/003, H04L 25/08

(54) **Bustreiber**
Bus driver
Circuit d'attaque de bus

(30) Priorität: 30.01.1998 DE 19803757
(43) Veröffentlichungstag der Anmeldung: 04.08.1999
(73) Patentinhaber: Infineon Technologies AG, 81669 München (DE)
(72) Erfinder: Ehben, Thomas, 81379 München (DE); Steinecke, Thomas, 85457 Hofsingelding (DE); Roemer, Dirk, 80637 München (DE); Kuenemund, Thomas, 80337 München (DE)
(74) Vertreter: Patentanwälte Westphal, Mussgnug & Partner

(56) Entgegenhaltungen:
- EP-A- 0 608 615
- US-A- 5 390 140
- US-A- 5 555 513
- PATENT ABSTRACTS OF JAPAN vol. 017, no. 401 (E-1404), 27. Juli 1993 & JP 05 075427 A (NEC CORP), 26. März 1993
- PATENT ABSTRACTS OF JAPAN vol. 012, no. 417 (P-782), 7. November 1988 & JP 63 155216 A (FUJITSU LTD), 28. Juni 1988
- PATENT ABSTRACTS OF JAPAN vol. 013, no. 220 (E-762), 23. Mai 1989 & JP 01 032523 A (NEC IC MICROCOMPUT SYST LTD), 2. Februar 1989
- PATENT ABSTRACTS OF JAPAN vol. 014, no. 576 (E-1016), 21. Dezember 1990 & JP 02 250526 A (NEC CORP), 8. Oktober 1990

## Beschreibung

Die Erfindung betrifft einen Bustreiber zum Treiben eines ersten Signals auf einer Busleitung, die kapazitiv gekoppelt ist mit mindestens einer weiteren Busleitung mit weiteren Signalen.

Beim Betreiben eines Busses kommt es häufig zur kapazitiven Kopplung benachbarter Busleitungen. Diese kapazitive Kopplung ist unerwünscht und kann im ungünstigsten Fall zur Störung und somit zu einer Veränderung der auf den Busleitungen getriebenen Signale führen. Der ungünstigste Fall der kapazitiven Kopplung tritt dann auf, wenn ein Signal auf einer benachbarten Busleitung eine entgegengesetzte Taktflanke aufweist, wie das zu treibende Signal. Wegen der zu erwartenden unerwünschten kapazitiven Kopplung muß das zu treibende Signal verstärkt werden und so an den ungünstigsten Fall einer kapazitiven Kopplung angepaßt zu sein. Diese Verstärkung führt jedoch zu unnötig schnellen Taktflanken des zu treibenden Signals. Diese schnellen Taktflanken sind jedoch ebenfalls unerwünscht, da sie eine elektromagnetische Abstrahlung verursachen, wodurch benachbarte Bauelemente störend beeinflußt werden können. Zur Verminderung dieser elektromagnetischen Abstrahlung und somit zur Verbesserung der elektromagnetischen Verträglichkeit (EMV) müssen daher Maßnahmen zur Anpassung an die jeweilige kapazitive Kopplung der Busleitungen getroffen werden.

Bisher wurden gattungsgemäße Bustreiber bei kapazitiver Kopplung mit benachbarten Busleitungen typischerweise an den ungünstigsten Fall, d. h. an den oben beschriebenen Fall, bei Auftreten von entgegengesetzten Taktflanken auf benachbarten Busleitungen, angepaßt. Diese sehr starre Dimensionierung, angepaßt an den ungünstigsten Fall der kapazitiven Kopplung, ist jedoch häufig auch nicht zufriedenstellend, da im Bereich außerhalb des oben beschriebenen Extremfalles eine zu große Kompensation stattfindet und somit zu steile, schnelle Taktflanken entstehen. Dadurch wird die elektromagnetische Abstrahlung maximiert.

Der vorliegenden Erfindung liegt daher die Aufgabe zugrunde, einen gattungsgemäßen Bustreiber bereitzustellen, dessen Treiberstärke dynamisch einstellbar ist.

Erfindungsgemäß wird diese Aufgabe durch einen Bustreiber nach Anspruch 1 gelöst.

Durch kapazitive Kopplung kann einem zu treibenden Signal auf einer Busleitung eines Busses ein Störsignal überlagert sein. Dieses Störsignal kann beispielsweise durch ein weiteres Signal auf mindestens einer benachbarten Leitung verursacht werden. Die benachbarten Leitung sind typischerweise die beiden benachbarten Busleitungen des Busses, können aber auch durch andere banachbarte Signalleitungen gebildet werden, die kapazitiv mit der Busleitung gekoppelt sind. Wesentlich hierbei ist lediglich, daß es zwischen dem zu treibenden Signal und einem Signal auf mindestens einer der benachbarten Leitung zu einer relativen Signalveränderung kommt. Die erfindungsgemäße Kompensationseinrichtung gleicht diese Störsignale schaltungstechnisch aus. Aus diese Weise kommt es zu keiner Veränderung des zu treibenden Signals durch eingekoppelte Störsignale.

Durch die vorliegende Erfindung wird somit eine dynamische Anpassung der Bustreiberstärke an die Signale der benachbarten kapazitiv gekoppelten Busleitungen ermöglicht.

Erfindungsgemäß ist dabei dem Hauptinverter, der das Signal auf der Busleitung treibt, eine Anzahl von Nebeninverter parallel zuschaltbar. Die Anzahl der Nebeninverter entspricht typischerweise der Anzahl der zur Busleitung kapazitiv gekoppelten, benachbarten Busleitungen.

Für den Fall eines eingekoppelten Störsignals, wird dem Hauptinverter mindestens einer der Nebeninverter zur Kompensation der Störsignale parallel zugeschaltet. Die Anzahl der dazugeschalteten Nebeninverter ergibt sich aus der Anzahl der kapazitiv gekoppelten benachbarten Busleitungen. Die Nebeninverter erzeugen ein Kompensationssignal, das dem zu treibenden Signal überlagert wird und das so das Störsignal ausgleicht.

Besonders vorteilhaft ist die Erfindung, wenn das zu treibende Signal der Busleitung getaktet ist. Typischerweise sind dann die Signale auf den benachbarten Busleitungen ebenfalls getaktet. Der ungünstigste Fall ergibt sich dann, wenn es gleichzeitig auf der Busleitung wie auch auf mindestens einer der benachbarten Busleitungen zu entgegengesetzten Taktflanken des getriebenen Taktsignals kommt. Bei einer entgegengesetzten Taktflanke auf einer der benachbarten Busleitungen wird für den Moment der Taktflanke einer der Nebeninverter zugeschaltet. Bei einer entgegengesetzten Flanke beider benachbarten Busleitungen werden zwei Nebeninverter zugeschaltet. Im Falle, daß keine entgegengesetzten Taktflanken auftreten, bleibt das zu treibende Signal unverändert.

Auf diese Weise kann eine definierte, optimale Flankensteilheit des Busleitungssignals eingestellt werden. Diese optimale Flankensteilheit ist im Hinblick auf eine optimale elektromagnetische Verträglichkeit sowie auf eine möglichst hohe Taktfrequenz des Bussystems optimiert.

Besonders vorteilhaft ist es, wenn die Nebeninverter dem Hauptinverter über einen steuerbaren Schalter parallel zuschaltbar sind. Die Ansteuerung erfolgt dabei über eine Ansteuerschaltung. Somit läßt sich jeder der Nebeninverter zum Zeitpunkt des auf der entsprechenden Busleitung auftretenden Störsignals dem Inverter zuschalten. In einer bevorzugten Ausführungsform ist auch dem Hauptinverter ein steuerbarer Schalter in Reihe geschaltet. Aus diese Weise kann der Bustreiber ebenfalls inaktiv gesetzt werden. Derartige Bustreiber mit, die über einen steuertbaren Schalter schaltbar sind, werden auch als "enablebare" Bustreiber bezeichnet.

Damit ein Signalwechsel auf den Busleitungen erkannt werden kann, ist jedem Bustreiber einer Busleitung eine Speichereinrichtung zur Erfassung von Signalwechseln vorgeschaltet. In einer typischen und einfachen Ausführungsform ist diese Speichereinrichtung durch ein einfaches Flip-Flop oder ein Latch realisiert. Das Signal am Eingang bzw. am Ausgang dieser Speichereinrichtung wird einer Ansteuerschaltung ist zugeführt. Am Ausgang dieser Ansteuerschaltung ist für jede der benachbarten kapazitiv gekoppelten Busleitungen ein Ansteuersignal abgreifbar, das dem jeweiligen steuerbaren Schalter des jeweiligen Nebeninverters zugeführt wird. Dieses Ansteuersignal charakterisiert die Signalveränderung zwischen dem zu treibenden Signal relativ zu dem Signal der entsprechenden benachbarten Busleitung und damit ein eingekoppeltes Störsignal.

Die Erfindung wird nachfolgend anhand der in den Figuren der Zeichnung angegebenen Ausführungsbeispiele näher erläutert. Es zeigt dabei:
- Figur 1: den prinzipiellen Aufbau eines erfindungsgemäßen Butreibers;
- Figur 2: die Schaltungsanordnung einer bevorzugten Ausgestaltung der Ansteuerschaltung;
- Figur 3: die Schaltungsanordnung eines Inverters oder Nebeninverters.

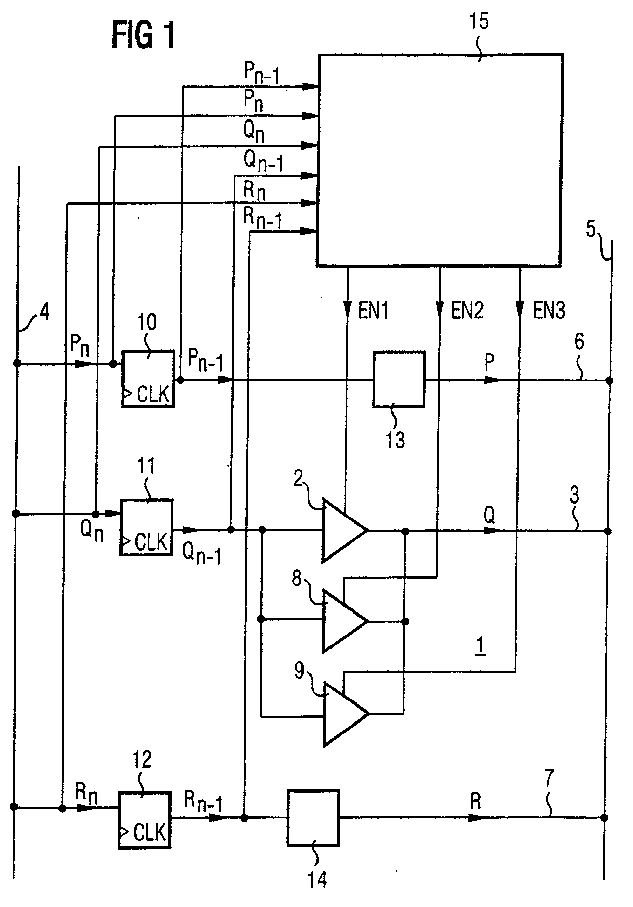

Figur 1 zeigt den prinzipiellen Aufbau eines erfindungsgemäßen Bustreibers, der im vorliegenden Beispiel zwei benachbarte, kapazitiv gekoppelte Busleitungen aufweist.

In Figur 1 ist mit 1 der Bustreiber bezeichnet. Der Bustreiber 1 enthält einen Inverter 2 zum Treiben eines getakteten Bussignals Q auf einer Busleitung 3 zwischen einem Buseingang 4 und einem Busausgang 5. Parallel zur Busleitung 3 sind im Ausführungsbeispiel in Figur 1 zwei weitere Busleitungen 6, 7 angeordnet, die kapazitiv zur ersten Busleitung 3 gekoppelt sind. Die weiteren Busleitungen 6, 7 sind ebenfalls zwischen dem Buseingang 4 und dem Buseingang 5 angeordnet und enthalten jeweils einen weiteren Bustreiber 13, 14. Die weiteren Bustreiber 13, 14 sind im vorliegenden Beispiel entsprechend zum Bustreiber 1 aufgebaut und treiben jeweils die weiteren getakteten Bussignale P, R.

Parallel zum Inverter 2 des Bustreibers 1 sind zwei Nebeninverter 8, 9 angeordnet. Die Anzahl der dem Inverter 2 parallel geschalteten Nebeninverter 8, 9 entspricht typischerweise der Anzahl der mit der Busleitung 3 kapazitiv gekoppelten weiteren Busleitungen 6, 7. Jedem der Bustreiber 1, 13, 14 ist jeweils eine Speichereinrichtung 10, 11, 12 vorgeschaltet. Im vorliegenden Ausführungsbeispiel werden die Speichereinrichtungen 10, 11, 12 jeweils durch ein RS-Flip-Flop gebildet. Die RS-Flip-Flops 10, 11, 12 weisen jeweils zwei Eingänge und jeweils einen Ausgang auf. In den jeweils ersten Eingang der RS-Flip-Flops 10, 11, 12 werden die getakteten Signal Pn, Qn, Rn zum Taktzeitpunkt t=n eingekoppelt. In den jeweils zweiten Eingang der RS-Flip-Flops 10, 11, 12 wird jeweils das Systemtaktsignal CLK eingekoppelt. Am Ausgang steht das um einen Takt des Systemtaktsignals CLK verzögerte getaktete Signal Pn-1, Qn-1, Rn-1 zum Taktzeitpunkt t=n-1 der entsprechenden Busleitung 3, 6, 7 bereit.

Zusätzlich ist in Figur 1 eine Ansteuerschaltung 15 vorgesehen. Der Ansteuerschaltung 15 werden eingangs jeweils die Taktsignale Pn, Qn, Rn sowie die jeweils um einen Takt verzögerten Taktsignale Signal Pn-1, Qn-1, Rn-1 eingekoppelt. Am Ausgang der Ansteuerschaltung 15 sind drei Ansteuersignale EN1, EN2, EN3 abgreifbar. Über diese Ansteuersignale EN1, EN2, EN3 lassen sich die Inverter 2, 8, 9 zuschalten oder abschalten.

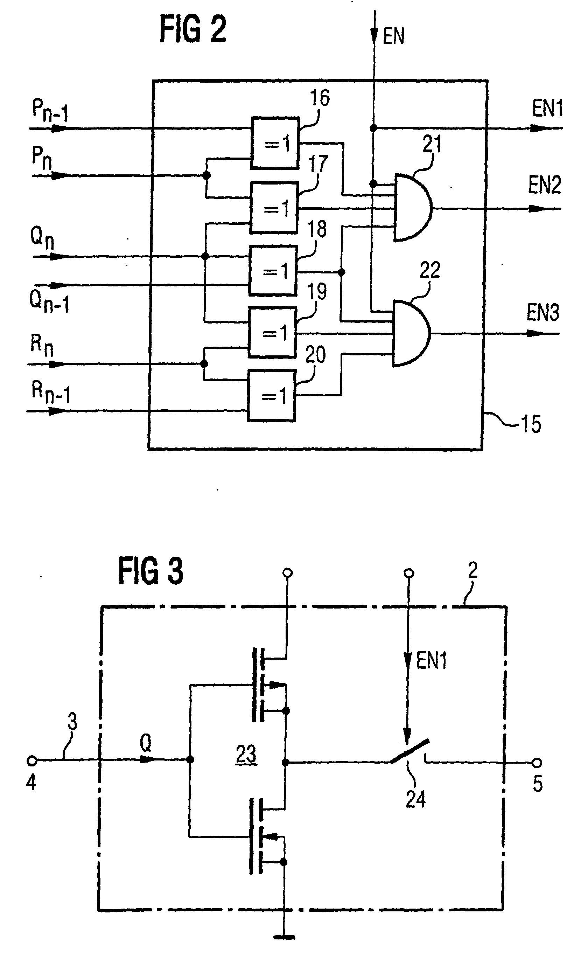

Figur 2 zeigt den detaillierten Aufbau einer bevorzugten Ansteuerschaltung entsprechend Figur 1. Gleiche bzw. funktionsgleiche Elemente sind entsprechend Figur 1 mit gleichen Bezugszeichen versehen.

Die Ansteuerschaltung 15 weist sechs Eingänge zur Einkopplung der Taktsignale Pn, Qn, Rn sowie der um einen Takt verzögerten Taktsignale Pn-1, Qn-1, Rn-1 für jede der Busleitungen 3, 6, 7 auf. Desweiteren weist die Ansteuerschaltung 15 drei Ausgänge auf, an denen die drei Ansteuersignale EN1, EN2, EN3 abgreifbar sind. Im vorliegenden Ausführungsbeispiel enthält die Ansteuerschaltung 15 eine Parallelschaltung von fünf Exclusive-Or-Gattern (XOR-Gattern) 16...20. Dem ersten XOR-Gatter 16 werden die Signale Pn, Pn-1 eingekoppelt. Dem zweiten XOR-Gatter werden die Signale Pn, Qn eingekoppelt. Dem dritten XOR-Gatter 18 werden die Signale Qn, Qn-1 eingekoppelt. Dem vierten XOR-Gatter 19 werden die Signale Qn, Rn eingekoppelt. Dem fünften XOR-Gatter werden die Signale Rn, Rn-1 eingekoppelt.

Der Parallelschaltung der XOR-Gatter 16...20 sind zwei parallel geschaltete UND-Gatter 21, 22, denen die Ausgangssignale der XOR-Gatter 16...20 zugeführt werden, nachgeschaltet. Dabei werden die Ausgangssignale der ersten drei XOR-Gatter 16, 17, 18 in das erste UND-Gatter 21 eingekoppelt. Die Ausgangssignale des dritten bis fünften EXO-Gatters 18, 19, 20 werden in das zweite UND-Gatter 22 eingekoppelt. Ausgangsseitig ist an den beiden UND-Gattern 21, 22 jeweils eines der Ansteuersignale EN2, EN3 abgreifbar.

In einer vorteilhaften Ausgestaltung entsprechend Figur 2 kann ein weiterer Eingang vorgesehen sein, in den ein sogenanntes Enable-Signal EN in die Ansteuerschaltung 15 eingekoppelt wird. Das Enable-Signal EN wird hier jedem der beiden UND-Gatter 21, 22 zugeführt. Zusätzlich wird das Enable-Signal EN an einem dritten Ausgang der Ansteuerschaltung 15 ausgekoppelt und bildet dann das Ansteuersignal EN1. Über das Enable-Signal EN lassen sich dann sowohl der Inverter 2 als auch die Nebeninverter 8, 9 des Bustreibers 1 abschalten. Ein derartiger Bustreiber wird üblicherweise als "enablebarer" Treiber bezeichnet.

Eine bevorzugte Ausführungsform eines Inverters 2 ist in Figur 3 gezeigt. Gleiche bzw. funktionsgleiche Elemente sind hier mit gleichen Bezugszeichen versehen.

Der enablebare Inverter 2 des Bustreibers weist hier einen CMOS-Inverterstufe 23 auf, der zwischen den zwei Polen der Versorgungsspannungsquelle angeordnet ist. Es wäre jedoch auch denkbar, daß die Inverterstufe 23 bipolar realisiert ist. Zwischen dem Mittelabgriff der Inverterstufe 23 und dem Busausgang 5 ist ein steuerbarer Schalter 24 angeordnet, dem als Steuersignal das Ansteuersignal EN1 zugeführt wird. Über den steuerbaren Schalter 24 läßt sich somit der Inverter 2 ein- bzw. ausschalten.

Die Erfindung ist jedoch nicht auf das Ausführungsbeispiel eines Inverter 2 entsprechend Figur 3 beschränkt, sondern ist für sämtliche Arten von Bustreibern 1 anwendbar.

Die Nebeninverter 8, 9 sind typischerweise aber nicht notwendigerweise wie der Inverter 2 aufgebaut.

Im vorliegenden Ausführungsbeispiel werden die Nebeninverter 8, 9 dem Inverter 2 nur dann zugeschaltet, wenn auf einer der benachbarten, kapazitiv gekoppelten Busleitungen 6, 7 eine zur Busleitung 3 entgegengesetzte Taktflanke auftritt. Die vorliegende Erfindung ist jedoch auf jede Art von störender Beeinflussung von Signalen auf benachbarten Leitungen anzuwenden. Die Signale müssen dabei nicht notwendigerweise getaktet sein. Für diesen Fall müßte jedoch die Ansteuerschaltung 15 sowie die den Invertern vorgeschalteten Speichereinrichtungen 10, 11, 12 an diesen Fall angepaßt werden und somit schaltungstechnisch komplexer ausgebildet sein.

Das Ausführungsbeispiel entsprechend Figur 1 geht von zwei benachbarten Busleitungen 6, 7 aus, die mit der Busleitung 3 kapazitiv gekoppelt sind. Desweiteren gehören die benachbarten Busleitungen 6, 7 zum selben Bus wie die Busleitung 3. Dies ist jedoch nicht zwingend notwendig. Die vorliegende Erfindung betrifft vielmehr einen Bustreiber 1 für eine Busleitung 3, die mit einer beliebigen Anzahl verschiedener Signalleitungen, die nicht notwendigerweise zum selben Bus wie die Busleitung 3 gehört, kapazitiv gekoppelt ist. In diesem Falle muß für jede der kapazitiv gekoppelten Signalleitungen jeweils ein Nebeninverter dem Inverter 2 des Bustreibers 1 parallel zuschaltbar sein.

Besonders vorteilhaft ist die vorliegende Erfindung bei Verwendung in einem Bustreiber eines Mikroprozessors.

## Patentansprüche

1. Bustreiber (1), dem ein erstes Signal (Qₙ₋₁) zugeführt ist zum Treiben dieses Signals auf einer Busleitung (3), die kapazitiv gekoppelt ist mit mindestens einer weiteren Busleitung (6, 7), auf der ein weiteres Signal getrieben wird,
**dadurch gekennzeichnet,**
**daß** eine die Bustreiberstärke dynamisch einstellende Kompensationsschaltung (8, 9, 15) vorgesehen ist, die bei einer Änderung des ersten Signals relativ zu dem mindestens einen weiteren Signal die durch diese Änderung verursachte Abweichung des ersten Signals kompensiert.

2. Bustreiber nach Anspruch 1,
**dadurch gekennzeichnet,**
**daß** der Bustreiber eine Inverterschaltung (2) zum Treiben des ersten Signals aufweist und daß die Kompensationseinrichtung(8, 9, 15) mindestens einen der Inverterschaltung (2) parallel zuschaltbaren Nebeninverter (8, 9) enthält.

3. Bustreiber nach Anspruch 2,
**dadurch gekennzeichnet,**
**daß** die Anzahl der Nebeninverter (8, 9) der Anzahl der weiteren Busleitungen (6, 7) entspricht.

4. Bustreiber nach einem der vorhergehenden Ansprüche,
**dadurch gekennzeichnet,**
**daß** mindestens das erste Signal getaktet ist.

5. Bustreiber nach Anspruch 4,
**dadurch gekennzeichnet,**
**daß** die Kompensationseinrichtung (8, 9, 15) immer dann eine definierte Flankensteigung des ersten getakteten Signals ausregelt, wenn mindestens eines der weiteren Signale eine zum ersten Signal entgegengesetzte Taktflanke aufweist.

6. Bustreiber nach einem der Ansprüche 4 oder 5,
**dadurch gekennzeichnet,**
**daß** die Anzahl der zum ersten Signal entgegengesetzten Taktflanken der weiteren Signale die Anzahl der weiteren Nebeninverter (8, 9) festlegt, die der Inverterschaltung (2) zugeschaltet werden.

7. Bustreiber nach einem der Ansprüche 2 bis 6,
**dadurch gekennzeichnet,**
**daß** zumindest einer der Inverter (2, 8, 9) einen über eine Ansteuerschaltung (15) ansteuerbaren steuerbaren Schalter (24) aufweist.

8. Bustreiber nach einem der vorhergehenden Ansprüche,
**dadurch gekennzeichnet,**
**daß** mindestens eine der Busleitungen (3, 6, 7) eine Speichereinrichtung (10, 11, 12) aufweist.

9. Bustreiber nach Anspruch 8,
**dadurch gekennzeichnet,**
**daß** mindestens eine der Speichereinrichtungen (10, 11, 12) ein Flip-Flop aufweist.

## Claims

1. Bus driver (1), to which a first signal (Qₙ₋₁) is fed, for driving this signal on a bus line (3), which is capacitively coupled to at least one further bus line (6, 7) on which a further signal is driven,
**characterized**
**in that** a compensation circuit (8, 9, 15) which dynamically adjusts the intensity of the bus driver is provided which, in the event of a change in the first signal relative to the at least one further signal, compensates for the deviation of the first signal caused by this change.

2. Bus driver according to Claim 1,
**characterized**
**in that** the bus driver has an inverter circuit (2) for driving the first signal, and in that the compensation device (8, 9, 15) contains at least one secondary inverter (8, 9) which can be connected in in parallel with the inverter circuit (2).

3. Bus driver according to Claim 2,
**characterized**
**in that** the number of secondary inverters (8, 9) corresponds to the number of further bus lines (6, 7).

4. Bus driver according to one of the preceding claims,
**characterized**
**in that** at least the first signal is clocked.

5. Bus driver according to Claim 4,
**characterized**
**in that** the compensation device (8, 9, 15) corrects a defined edge gradient of the first clocked signal whenever at least one of the further signals has a timing edge opposite to the first signal.

6. Bus driver according to either of Claims 4 and 5,
**characterized**
**in that** the number of timing edges of the further signals opposite to the first signal defines the number of further secondary inverters (8, 9) which are connected in with the inverter circuit (2).

7. Bus driver according to one of Claims 2 to 6,
**characterized**
**in that** at least one of the inverters (2, 8, 9) has a controllable switch (24), which can be activated by means of an activating circuit (15).

8. Bus driver according to one of the preceding claims,
**characterized**
**in that** at least one of the bus lines (3, 6, 7) has a storage device (10, 11, 12).

9. Bus driver according to Claim 8,
**characterized**
**in that** at least one of the storage devices (10, 11, 12) has a flip-flop.

## Revendications

1. Pilote de bus (1) recevant un premier signal (Qₙ₋₁) pour transmettre ce signal par un bus (3), avec couplage capacitif, ayant au moins une autre ligne de bus (6, 7) qui transmet un autre signal,
**caractérisé en ce qu'**
en cas de variation du premier signal par rapport à au moins l'autre signal, un circuit de compensation (8, 9, 15), qui règle de manière dynamique la puissance du bus, compense la déviation du premier signal produite par cette variation.

2. Pilote de bus selon la revendication 1,
**caractérisé en ce qu'**
il comporte un circuit inverseur (2) pour piloter le premier signal et l'installation de compensation (8, 9, 15) comporte au moins un inverseur auxiliaire (8, 9) qui peut être branché en parallèle à l'inverseur (2).

3. Pilote de bus selon la revendication 2,
**caractérisé en ce que**
le nombre d'inverseurs auxiliaires (8, 9) correspond au nombre des autres lignes de bus (6, 7).

4. Pilote de bus selon l'une des revendications précédentes,
**caractérisé en ce qu'**
au moins le premier signal est découpé.

5. Pilote de bus selon la revendication 4,
**caractérisé en ce que**
l'installation de compensation (8, 9, 15) régule toujours une pente définie du flanc du premier signal découpé si au moins l'un des autres signaux présente un flanc de découpage opposé au premier signal.

6. Pilote de bus selon l'une des revendications 4 ou 5,
**caractérisé en ce que**
le nombre de flancs du découpage des autres signaux, à l'opposé du premier signal, fixe le nombre des autres inverseurs auxiliaires (8, 9) qui peuvent être branchés dans le circuit inverseur (2).

7. Pilote de bus selon l'une des revendications 2 à 6,
**caractérisé en ce qu'**
au moins l'un des inverseurs (2, 8, 9) comporte un commutateur commandé (24) dont la commande se fait par un circuit de commande (15).

8. Pilote de bus selon l'une des revendications précédentes,
**caractérisé en ce qu'**
au moins l'une des lignes de bus (3, 6, 7) comporte une installation de mémoire (10, 11, 12).

9. Pilote de bus selon la revendication 8,
**caractérisé en ce qu'**
au moins l'une des installations de mémoire (10, 11, 12) comporte une bascule bistable (Flip-Flop).
